Europäisches Patentamt

European Patent Office

Office européen des brevets

(11) Numéro de publication: **0 246 935**
**A1**

## (12) DEMANDE DE BREVET EUROPEEN

(21) Numéro de dépôt: **87400834.5**

(22) Date de dépôt: **13.04.87**

(51) Int. Cl.⁴: **H 03 K 17/94**

(30) Priorité: **21.04.86 FR 8605699**

(43) Date de publication de la demande:
**25.11.87   Bulletin   87/48**

(84) Etats contractants désignés:
**AT BE CH DE ES GB GR IT LI LU NL SE**

(71) Demandeur: **FERCO INTERNATIONAL Usine de Ferrures de Bâtiment Société à responsabilité limitée dite**
**2, rue du Vieux-Moulin Reding**
**F-57400 Sarrebourg  (FR)**

(72) Inventeur: **Marmet, Patrick**
**12, Avenue de France**
**F-57400 Sarrebourg  (FR)**

(74) Mandataire: **Rodhain, Claude et al**
**Cabinet Claude Rodhain 30, rue la Boétie**
**F-75008 Paris  (FR)**

(54) **Clavier pour appareil électrique.**

(57) Le clavier comporte plusieurs emplacements en matrice repérés par un caractère alphanumérique, répondant à une excitation par une modification d'une grandeur électrique, et au moins un détecteur d'analyse en face de chaque emplacement et branché dans un circuit (7) d'analyse délivrant un signal de sortie constitué par ladite modification de grandeur électrique lors d'une telle excitation se traduisant par une modification d'éclairement dudit détecteur. Le clavier est caractérisé par des emplacements non repérés et également susceptibles de répondre à une excitation en provoquant une modification de la grandeur électrique ainsi que des détecteurs de référence (4) en face des emplacements non repérés et reliés à des entrées d'un circuit de référence (8) comportant au moins un amplificateur (81) et dont la sortie est reliée à chaque circuit d'analyse (7) pour leur fournir un signal de référence fonction de l'excitation desdits emplacements non repérés ; les détecteurs (3, 4) sont des semi-conducteurs photosensibles tels que des phototransistors, logés dans des cavités (5) d'une même plaque de base (1) pour être tous placés dans les mêmes conditions.

Le clavier peut être utilisée notamment pour le verrouillage ou le déverrouillage de divers dispositifs, par exemple des portes de bâtiments.

FIG.3

FIG.2

## Description

"Clavier pour appareil électrique".

L'invention concerne un clavier pour appareil électrique, du type comportant plusieurs emplacements susceptibles de répondre à une excitation locale, en provoquant une modification correspondante dans au moins un circuit électrique, par exemple un changement d'état.

De tels claviers sont utilisés très largement en électronique et en informatique, par exemple sur les téléphones, les calculatrices de poche, les ordinateurs, les portiers de villas et immeubles par exemple.

On connaît ainsi depuis très longtemps des claviers électromécaniques dits "à boutons poussoirs", dans lesquels les emplacements mentionnés plus haut sont des touches et l'excitation est une pression exercée sur celles-ci; le plus souvent, cette pression provoque un changement d'état du circuit électrique, à savoir une ouverture ou une fermeture du circuit selon l'état initial de celui-ci, un interrupteur étant associé à chaque touche et lié mécaniquement à celle-ci; ces claviers sont sujets à des pannes mécaniques dûes soit à une manipulation trop brutale, soit à une usure normale en cas d'usage intensif, et également à des pannes électriques au niveau de leurs contacts; de plus, ils ne présentent pas une très grande résistance aux actes de vandalisme, du fait que les touches peuvent être relativement facilement coincées ou arrachées par exemple; également, à cause de la présence de pièces mobiles accessibles de l'extérieur, ces claviers ont une tenue climatique médiocre, et une étanchéité difficile à assurer, particulièrement lorsqu'ils sont destinés à équiper des appareils extérieurs à des locaux tels que des "portiers" de villas ou d'immeubles; il en résulte une durée de vie relativement réduite, pour des appareils d'un coût souvent élevé et par ailleurs de plus en plus nombreux dans notre environnement quotidien.

Plus récemment, en vue de remédier autant qu'il était possible à ces problèmes, sont apparus des claviers toujours électromécaniques, mais à élastomère, et des claviers à relais à lames souples, lesquels sont, comme les claviers classiques, des claviers dits "contactants",car ils exigent pour fonctionner, d'exercer une pression faible mais réelle, à un emplacement jouant le rôle de poussoir. Ces claviers sont plus fiables que les précédents, mais le grand nombre de pièces mobiles est encore cependant une source de pannes.

Enfin, sont apparus des claviers "non contactants", ou encore dits à touches "à effleurement" ou "sensitives" parce qu'il n'est pas nécessaire d'exercer une pression sur elles pour provoquer l'ouverture ou la fermeture du circuit électrique associé, le simple fait de les toucher ou même de les effleurer sans contact ayant ce résultat,par suite de la mise en oeuvre de phénomènes électrostatiques, électromagnétiques, dans des tores de ferrite par exemple, ou encore de l'effet Hall; dans ce cas, l'ouverture et la fermeture du circuit électrique associé aux touches est avantageusement obtenue au moyen d'une commutation électronique. Ces claviers sont donc beaucoup moins sujets aux pannes mécaniques, et présentent une meilleure résistance au vandalisme, dans la mesure où ils n'ont aucune pièce mobile accessible extérieurement. Néanmoins, ils sont encore sensibles aux conditions climatiques et également aux perturbations atmosphériques se traduisant électromagnétiquement par exemple.

La présente invention a pour but de remédier à ces inconvénients et concerne à cet effet un clavier pour appareil électrique, du type comportant plusieurs emplacements disposés en matrice et repérés par un caractère alphanumérique respectif, susceptibles de répondre à une excitation locale en provoquant une modification correspondante du niveau d'une grandeur électrique, et au moins un détecteur d'analyse disposé en face de chaque emplacement et branché dans un circuit électrique d'analyse adapté à délivrer un signal de sortie constitué par ladite modification de niveau de la grandeur électrique lors d'une telle excitation de l'emplacement correspondant se traduisant par une modification d'éclairement dudit détecteur, clavier caractérisé en ce qu'il comporte des emplacements non repérés et également susceptibles de répondre à une excitation locale en provoquant une modification correspondante du niveau de la même grandeur électrique ainsi que des détecteurs de référence qui sont disposés en face de ces emplacements non repérés et sont reliés à des entrées d'un circuit de référence comportant au moins un amplificateur et dont la sortie est reliée à chaque circuit d'analyse pour leur fournir un signal de référence qui est fonction de l'excitation desdits emplacements non repérés, et en ce que tous les détecteurs sont des détecteurs de lumière constitués de composants semi-conducteurs photosensibles tels que des phototransistors, logés dans des cavités creusées dans une même plaque de base de telle sorte qu'ils soient tous placés dans les mêmes conditions en l'absence d'excitation d'au moins l'un d'entre eux.

Grâce au fait que le circuit électrique est commandé par des détecteurs tels que des détecteurs de lumière fonctionnant en réponse à une différence de niveau d'intensité lumineuse, on peut éviter toute émergence de la partie fonctionnelle du clavier hors du plan de son support. Il en résulte une protection efficace contre le vandalisme et une diminution sensible du nombre de cas où il est nécessaire de procéder à un remplacement onéreux d'éléments transmetteurs d'ordre ou de données; comme le clavier comporte des emplacement non repérés et également susceptibles de répondre à une excitation locale de la même manière que les emplacements alphanumériques, et des détecteurs de référence disposés de même que les détecteurs d'analyse et reliés à un circuit de référence pour fournir aux circuits d'analyse un signal de référence, et comme les détecteurs sont noyés dans une même plaque de base, le fonctionnement du clavier est indépendant des conditions ambiantes et des perturbations involontaires.

Selon une caractéristique de l'invention, le circuit associé au détecteur de lumière est susceptible d'être parcouru par un courant dont l'intensité est variable entre deux valeurs dont l'une est pratiquement nulle.

D'autres caractéristiques et avantages de l'invention ressortiront de la description qui va suivre se rapportant à des formes de réalisation préférentielles données à titre d'exemples non limitatifs, illustrés sur les dessins ci-joints, dans lesquels :

- la Fig. 1 est une vue de face schématique d'un clavier selon l'invention,

- la Fig. 2 est une section du clavier de la figure 1 selon la ligne II-II de cette figure 1,

- la Fig. 3 est un schéma électronique de principe d'une partie des circuits électroniques dont est muni ce clavier,

- la Fig. 4 est une variante au schéma électronique de la Figure 3.

Le clavier représenté sur les figures est un clavier solide non contactant transmetteur d'ordres ou de données au moyen d'impulsions électriques générées sous commande optique.

Ce clavier peut recevoir d'innombrables applications, et étant particulièrement bien adapté à résister aux intempéries, est susceptible d'être avantageusement utilisé dans les dispositifs de condamnation du verrouillage ou du déverrouillage des portes de bâtiments.

En effet, sa base mécanique est une plaque métallique rectangulaire 1, munie dans l'une de ses faces, d'un logement lui-même rectangulaire dans lequel est encastré, sans dépasser du plan de la périphérie da la plaque métallique, une plaque de protection 2, transparente ou au moins translucide, pour des détecteurs de lumière 3,4 insérés dans des cavités 5 traversant la plaque métallique 1 de part en part.

Les détecteurs de lumière, ici des phototransistors, ont leur surface sensible tournée vers la plaque de protection, laquelle est en verre ou en matière plastique de quelques milimètres d'épaisseur, et leurs conducteurs de liaison, à l'opposé, sont soudés à une plaque de circuit imprimé 6.

Dans l'exemple décrit, les phototransistors sont au nombre de quatorze ; douze d'entre eux sont des phototransistors d'analyse 3 répartis dans une disposition en matrice à quatre lignes et trois colonnes, et les détecteurs supplémentaires 4, de référence, sont dans l'alignement de la colonne centrale respectivement au-dessus et au-dessous de la première et de la dernière lignes, ici à une distance de ces lignes égale à l'espacement entre deux lignes.

Bien entendu, on peut choisir pour les détecteurs toute disposition dictée par des considérations esthétiques ou par des impératifs techniques ou pratiques.

La totalité des détecteurs 3,4 est disposée dans la partie de la plaque de base 1 qui est en regard de la plaque de protection 2, de telle sorte que tous ceux-ci puissent être excités par toute lumière incidente, que ce soit la lumière du jour, ou celle d'un éclairage extérieur, ou encore une lumière d'appoint émise à proximité du clavier, à l'exception éventuellement de l'un des détecteurs 3 masqué par l'utilisateur, par exemple au moyen de l'extrémité de l'un de ses doigts.

En face de chaque détecteur d'analyse 3 est inscrit un signe typographique, par exemple un chiffre de 0 à 9 ou une lettre (caractère alphanumérique).

La plaque de circuit imprimé 6 porte l'électronique d'exploitation des signaux émis par les phototransistors 3,4.

Cette électronique comporte notamment d'une part autant de circuits d'analyse 7 que de détecteurs d'analyse 3, et un circuit de référence 8 correspondant aux deux détecteurs de référence 4 et destiné à fournir aux circuits d'analyse le niveau de référence, toute transition vers un niveau sensiblement différent et correspondant à une lumière plus faible constituant donc un signal utile.

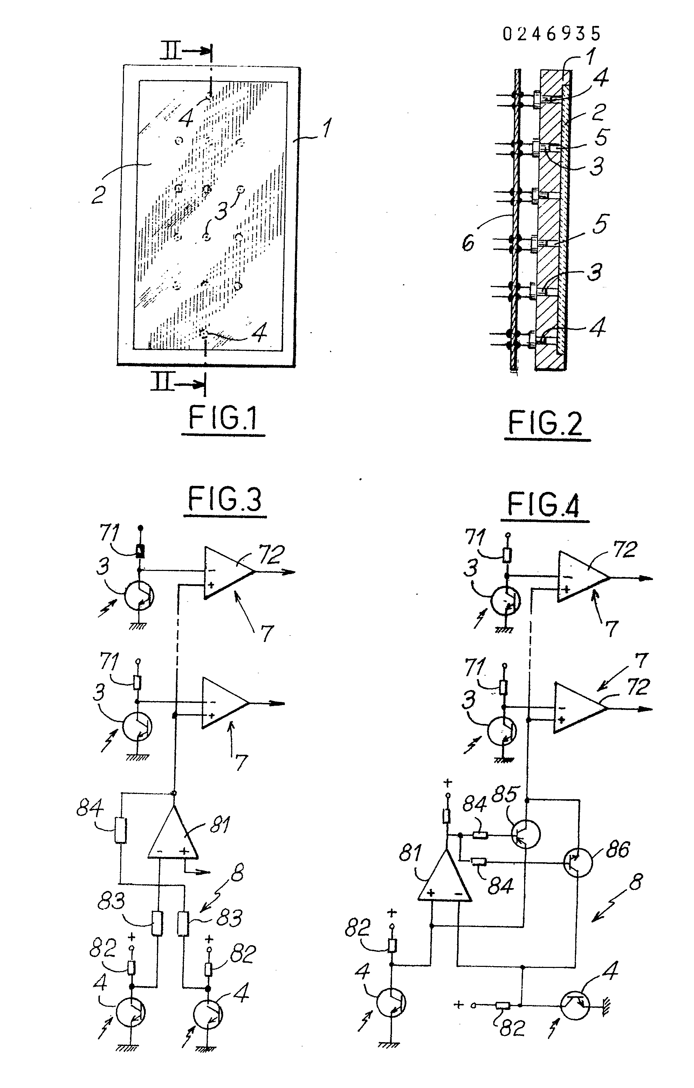

Le circuit de référence 8 peut être envisagé sous plusieurs formes, deux d'entre elles étant représentées respectivement sur les figures 3 et 4.

Sur la figure 3, les deux phototransistors de référence 4 attaquent la même entrée d'un amplificateur opérationnel 81 ; a cet effet, ils sont alimentés chacun en montage émetteur commun par une source continue, leur collecteur étant relié au pôle positif de la source par l'intermédiaire d'une résistance 82, et à l'entrée de l'amplificateur 81 par une autre résistance 83 ; le gain de l'amplificateur opérationnel est réglé par une résistance de contre-réaction 84. C'est donc la somme des courants de sortie des phototransistors 4 qui attaque l'amplificateur (ce qui revient au même que la moyenne de ces courants). La sortie de l'amplificateur 81 est reliée à chacun des circuits d'analyse 7.

Sur la figure 4, les deux phototransistors 4, également en montage émetteur commun (collecteur relié au pôle positif de la source par une résistance 82), attaquent chacun une entrée différente de l'amplificateur opérationnel 81 ; la boucle de contre-réaction de chaque entrée de l'amplificateur 81 monté en comparateur comporte en série une résistance 84, et pour l'entrée positive, l'espace émetteur-bas d'un transistor 85, et, pour l'entrée négative, l'espace collecteur-base d'un autre transistor 86, le collecteur du premier transistor et l'émetteur du second étant connectés l'un à l'autre et reliés à chacun des circuits d'analyse 7. Il en résulte que c'est pratiquement le signal issu du phototransistor 4 le moins éclairé qui sert de référence aux circuits d'analyse 7.

Chacun des circuits d'analyse 7 comporte un phototransistor 3 en montage émetteur commun (collecteur relié à une source positive par une résistance 71) dont le collecteur est par ailleurs relié à une entrée (négative) d'un amplificateur opérationnel 72 monté en comparateur de niveau dont l'autre entrée (positive) est reliée au circuit de référence 8 de la manière qui est décrite plus haut pour en recevoir un signal électrique correspondant au niveau de la luminosité générale. La sortie des circuits d'analyse 7 attaque les étages suivants en cascade comme cela est classique. De la sorte, les détecteurs de référence 4 captent la lumière ambiante ou la lumière émise par une source d'appoint associée au clavier, et prennent en compte le niveau lumineux de cette lumière en tant que niveau de référence. On dispose donc d'un niveau de référence en permanence, et l'on peut ainsi s'affranchir de l'existence d'ne ombre portée par la main lors de l'utilisation, de même que de toutes les variations de luminosité ambiante, que le clavier soit placé sur une porte de sécurité d'un local, dans un bâtiment ou sur une porte d'entrée d'immeuble.

Ainsi, l'occultation d'une cavité 5 et du détecteur 3 qui y est logé, par l'extrémité d'un doigt de l'utilisateur, rempli la même fonction que la pression ou l'effleurement d'une touche d'un clavier standard : le détecteur d'analyse 3 occulté subit une transition de courant qui est appliquée à l'entrée négative du comparateur d'analyse 72 correspondant; ce comparateur 72 ayant son autre entrée (positive) attaquée par le signal de référence issu du circuit de référence 8, effectue la comparaison des signaux à ses entrées et présente donc à sa sortie un signal sous la forme d'un état logique tout ou rien (0 ou 1) en fonction de l'occultation ou non de la cavité 5 au droit du détecteur 3; ce signal peut être exploité selon les techniques utilisées habituellement dans le domaine des claviers connus, et l'occultation successive de plusieurs cavités déclenche optiquement une série d'impulsions électriques pouvant servir par exemple au déverrouillage d'une porte pallière ou d'immeuble, ou encore à un verrouillage, à une condamnation quelconque ou à un autre usage tel qu'une transmission d'ordre (s) ou de donnée(s) à un système électronique ou informatique comme n'importe quel autre clavier contactant ou non contactant, avec tous les avantages résultant de l'utilisation de l'électronique tels qu'une signalisation sonore ou une visualisation lumineuse de contrôle ou de résultat d'une action comparable à la manipulation d'une touche. On peut noter que bien que la description se réfère à un montage utilisant des transistors NPN, elle s'applique également mutatis mutandis à des transistors PNP.

Bien entendu, l'invention n'est pas limitée aux formes de réalisation ci-dessus décrites et représentées, et on pourra prévoir d'autres formes de réalisation sans pour autant sortir de son cadre.

## Revendications

1o - Clavier pour appareil électrique, du type comportant plusieurs emplacements disposés en matrice et repérés par un caractère alphanumérique respectif, susceptibles de répondre à une excitation locale en provoquant une modification correspondante du niveau d'une grandeur électrique, et au moins un détecteur d'analyse disposé en face de chaque emplacement et branché dans un circuit électrique (7) d'analyse adapté à délivrer un signal de sortie constitué par ladite modification de niveau de la grandeur électrique lors d'une telle excitation de l'emplacement correspondant se traduisant par une modification d'éclairement dudit détecteur, clavier caractérisé en ce qu'il comporte des emplacements non repérés et également susceptibles de répondre à une excitation locale en provoquant une modification correspondante du niveau de la même grandeur électrique ainsi que des détecteurs de référence (4) qui sont disposés en face de ces emplacements non repérés et sont reliés à des entrées d'un circuit de référence (8) comportant au moins un amplificateur (81) et dont la sortie est reliée à chaque circuit d'analyse (7) pour leur fournir un signal de référence qui est fonction de l'excitation desdits emplacements non repérés, et en ce que tous les détecteurs (3, 4) sont des détecteurs de lumière constitués de composants semi-conducteurs photosensibles tels que des phototransistors, logés dans des cavités (5)creusées dans une même plaque de base (1) de telle sorte qu'ils soient tous placésdans les mêmes conditions en l'absence d'excitation d'au moins l'un d'entre eux.

2o - Clavier selon la revendication 1, caractérisé en ce qu'il comporte une plaque de base (1) munie d'un logement dans lequel est encastrée une plaque de protection (2) pour les détecteurs (3, 4), laquelle plaque de détection est encastrée sans dépasser du plan de la plaque de base.

3o - Clavier selon la revendication 1, caracatérisé en ce que le circuit de référence (8) comporte un amplificateur (81) dont une entrée est reliée aux deux détecteurs (4) par l'intermédiaire d'une résistance respective (83), par fournir en sortie un signal fonction de la somme des courants de sortie des détecteurs (4).

4o - Clavier selon la revendication 1, caractérisé en ce que le circuit de référence (8) comporte un amplificater monté en comparateur, dont deux entrées sont branchées respectivement aux deux détecteurs (4) de référence, pour fournir en sortie un signal fonction du courant de sortie du détecteur (4) le moins excité.

0246935

FIG.1

FIG.2

FIG.3

FIG.4

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | EP-A-0 163 138   (ENERGY CONVERSION DEVICES) <br> * Page  4, lignes 14-22; page 5, ligne 32 - page 7, ligne 5;  figures 1,2 * | 1,2 | H 03 K   17/94 |
| A | US-A-4 329 581  (HELFRICH, Jr. et al.) <br> * Colonne  2, ligne 40 - colonne 3, ligne 53; figures 1,2 * | 1 | |
| A | GB-A-1 238 428  (NATIONAL CASH REGISTER CO.) <br> * Page 1, lignes 72-86; figure  2 * | 1 | |

DOMAINES TECHNIQUES
RECHERCHES (Int. Cl.4)

H 03 K
H 03 M
B 41 J
G 06 K

Le présent rapport de recherche a été établi pour toutes les revendications

| Lieu de la recherche | Date d'achèvement de la recherche | Examinateur |
|---|---|---|
| LA HAYE | 07-09-1987 | CANTARELLI R.J.H. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82